Europäisches Patentamt

European Patent Office

Office européen des brevets

(11) Publication number: **0 451 968 A1**

# EUROPEAN PATENT APPLICATION

(21) Application number: 91302289.3

(51) Int. Cl.⁵: **H01L 21/336**

(22) Date of filing: **18.03.91**

(30) Priority: **11.04.90 GB 9008214**

(43) Date of publication of application:
**16.10.91 Bulletin 91/42**

(84) Designated Contracting States:
**DE FR GB NL**

(71) Applicant: **THE GENERAL ELECTRIC COMPANY, p.l.c.**
**1 Stanhope Gate**
**London W1A 1EH(GB)**

(72) Inventor: **Coxon, Penelope Anne**
**30 Rosebery Way**
**Tring, Hertfordshire, HP23 5DS(GB)**

(74) Representative: **George, Sidney Arthur**
**The General Electric Company p.l.c. GEC**
**Patent Department(Wembley Office) Hirst**
**Research Centre East Lane**
**Wembley Middlesex, HA9 7PP(GB)**

(54) **Process for manufacturing thin film transistor.**

(57) In a process for manufacturing a thin film transistor, a first polysilicon layer (11) is formed on a substrate, a dielectric layer (12) is formed on part of the first layer, and a second polysilicon layer (13) is formed on, and over the same area as, the dielectric layer. A layer (14) of refractory metal, such as titanium, is then deposited on the second polysilicon layer and on the exposed regions of the first polysilicon layer. A reaction is then caused, for example, by annealing, between the metal layer and the polysilicon layer so that silicide regions are formed to provide source, gate and drain electrodes (15,16,17). Unreacted areas of the metal layer are then removed by selective etching.

Fig. 2(a).

Fig. 2(b).

Fig. 2(c).

Fig. 2(d).

Fig. 2(e).

Fig. 2(f).

*Fig.2(g).*

*Fig.2(h).*

*Fig.2(i).*

*Fig.2(j).*

This invention relates to the manufacture of thin film transistors (TFTs) by the deposition of polysilicon.

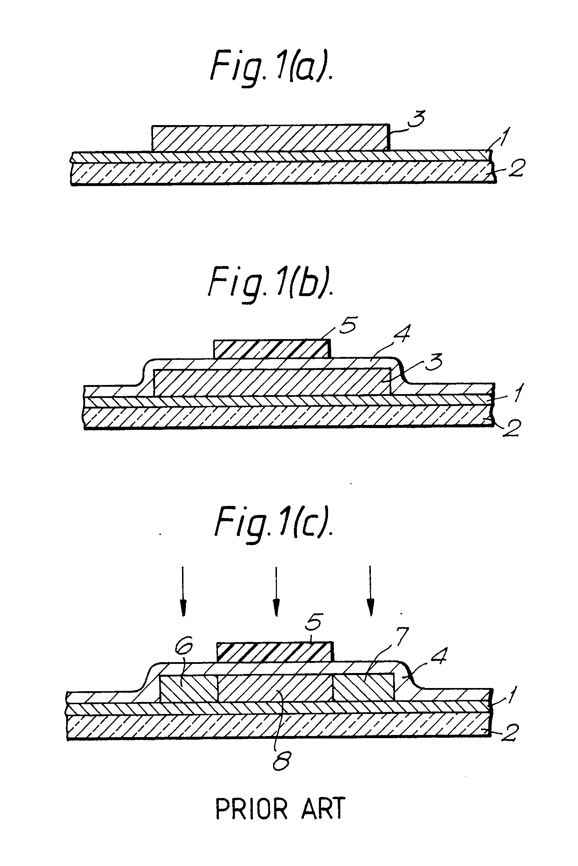

Figure 1 of the accompanying drawings illustrates the first steps in a well-known process for the formation of a polysilicon TFT. Firstly, a layer 1 (Figure 1(a)) of silicon dioxide is deposited on a glass substrate 2. A layer 3 of polysilicon is then formed over a region of the silicon dioxide layer. A further layer 4 (Figure 1(b)) of silicon dioxide is formed on the layer 3, and a gate region 5 of polysilicon is formed on the layer 4. The gate region 5, and regions 6 and 7 of the layer 3 projecting beyond the gate region, are then doped (Figure 1(c)) by ion implantation to form gate, source and drain regions, respectively, of n$^+$ polysilicon. Contact layers (not shown) are subsequently formed over the regions. During the ion implantation process, the gate region 5 acts as a mask, which should prevent doping of the central region 8 of the layer 3. However, unless very careful control over the ion implantation process is maintained, the doped regions 6 and 7 will extend underneath the gate region 5, forming parasitic capacitances between the gate and the source and between the gate and the drain. The capacitances will reduce the speed of operation of the device. The junctions formed in the polysilicon by the known process are not well-defined, because enhanced diffusion of the dopant down the grain boundaries occurs during annealing of the device.

Furthermore, the ion implantation process accounts for a major part of the cost of forming the device. Moreover, ion implantation is not suitable for the production of TFTs over a large area.

In an alternative known process, (not shown), doped source and drain regions similar to the regions 6 and 7 are deposited on the lower silicon dioxide layer. A layer of polysilicon is formed over those regions, followed by a silicon dioxide layer. A doped gate region similar to the region 5 is then formed centrally on the silicon dioxide layer. There is a considerable likelihood that the gate region will overlap the edges of the source and drain regions, and parasitic capacitances such as mentioned above will result.

It is an object of the present invention to provide a process for manufacturing polysilicon TFTs which does not involve the use of ion implantation to produce the conductive regions, and in which the production of the above-mentioned parasitic capacitances is avoided.

According to the invention there is provided a process for manufacturing a thin film transistor, comprising the steps of forming a first polysilicon layer on a substrate; forming a second polysilicon layer over a region of said first polysilicon layer and insulated therefrom by a dielectric layer of the same area as said second polysilicon layer; depositing on said second polysilicon layer and on the exposed regions of said first polysilicon layer a layer of refractory metal; and causing a reaction between the metal layer and the polysilicon layers whereby silicide regions are formed to provide source, gate and drain electrodes.

An embodiment of the invention will now be described, by way of example, with reference to the accompanying drawings, in which

Figure 1 illustrates steps in a known TFT manufacturing process as described hereinbefore, and

Figure 2 illustrates steps in a process in accordance with the invention.

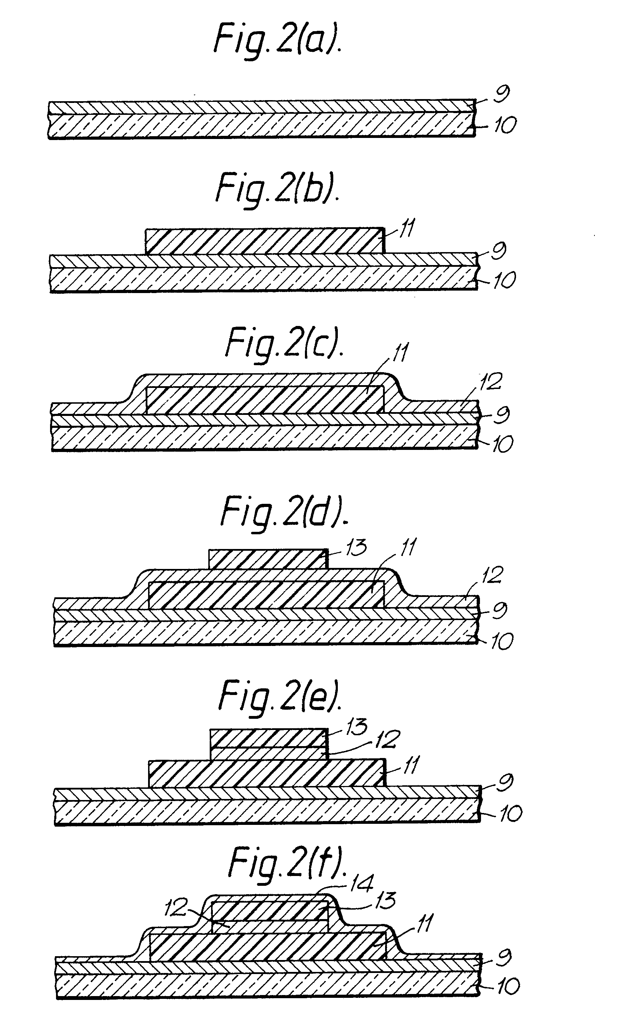

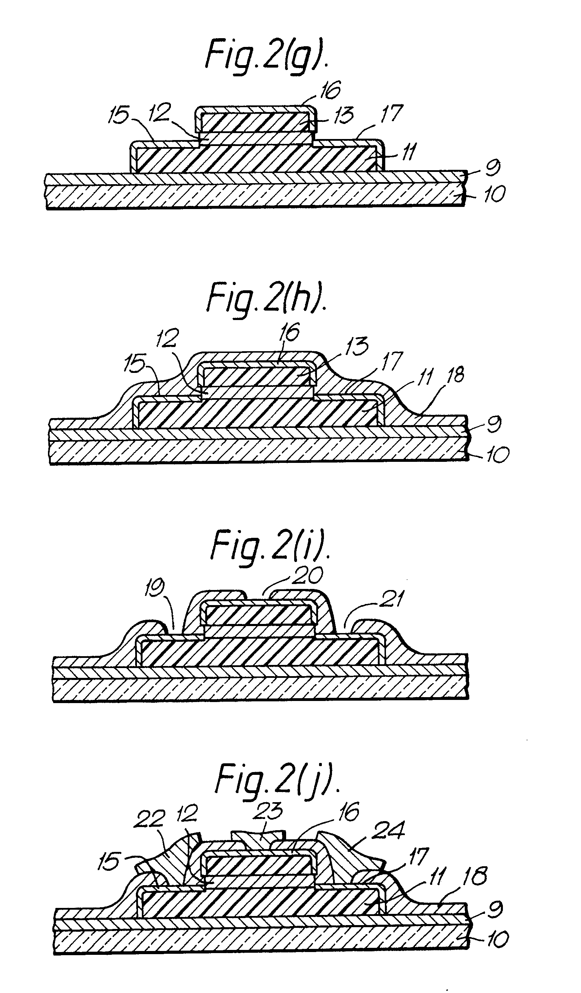

Referring to Figure 2(a), in a process in accordance with the invention a layer 9 of silicon dioxide is deposited on a substrate 10 of glass or other suitable material. A layer 11 of polysilicon (Figure 2(b)) is then formed over a region of the silicon dioxide layer 9. A thin (e.g. 1000Å thick) layer 12 of silicon dioxide (Figure 2(c)) is formed over the preceding layers, and a thin (e.g. 1000Å thick) layer 13 of polysilicon (Figure 2(d)) is deposited on the dielectric layer 12, over a central region of the polysilicon layer 11, to act as the gate of the TFT.

The areas of the dielectric layer 12 which are not covered by the layer 13 are then removed by etching (Figure 2(e)), and a thin film (e.g. of 500Å thickness) 14 of titanium is deposited over the device by evaporation (Figure 2(f)). The device is then subjected to an annealing process, during which titanium silicide is formed on the polysilicon layers 11 and 13. The annealing period must be long enough for an adequate titanium/silicon reaction to take place, but not sufficiently long for the silicon to diffuse so far through the titanium layer that there is a danger of shorting between the gate electrode and the source and drain regions due to silicide formation on the edges of the dielectric layer 12. For example, the annealing may be affected at 600°C for ten minutes. In general, the annealing temperature should be greater than 500°C, unless ion bombardment is used to encourage the titanium/silicon reaction. During the annealing process, various unwanted products are formed by reactions on the dielectric layers.

The layer 14 is then subjected to a selective etching process, which removes the unreacted areas of the layer 14 together with the above-mentioned unwanted products. The etching may be effected by, for example, ammonium hydroxide or a 1:1 mixture of hydrogen peroxide and sulphuric acid. Silicided areas 15,16 and 17 (Figure 2(g)) are thereby left on the source, gate and drain regions.

The device is then annealed again, preferably for a longer period, to complete the titanium/silicon reaction, thereby stabilising the silicided areas. An annealing period of 60 minutes at 600°C is proposed.

The silicided areas provide source, gate and drain contacts, and the need to provide heavily-doped source and drain regions is thereby avoided.

An insulating layer 18 (Figure 2(h)) formed, for example, of silicon dioxide, is deposited over the device, apertures 19, 20 and 21 are formed therethrough (Figure 2(i)), and a layer of aluminium is deposited and etched to provide source, gate and drain contacts 22,23 and 24, respectively (Figure 2-(j)).

Although in the preceding description titanium is proposed for the layer 14, other refractory metals, such as molybdenum, chromium and tungsten, might be used. The annealing periods and temperatures may then require appropriate adjustment.

The metal layer 14 is preferably evaporated on to the device, as indicated above, in order to reduce deposition on to the vertical edges (as viewed in the figures) of the layers. The thickness of the layer is chosen to be appreciably less than the thickness of the gate dielectric layer 12, but sufficiently thick to provide an adequate silicide formation.

The unusually thin polysilicon gate electrode layer 13 is used in order to reduce the capacitance of the electrode, which would otherwise be larger than usual due to the use of undoped polysilicon.

As mentioned above, the provision of the self-aligned silicided regions alone to make contact with the channel region obviates the need for the conventional expensive ion implantation process for providing the source, gate and drain electrodes. Indeed, the polysilicon layers 11 and 13 can be completely undoped. It is found that the Schottky barriers formed in the present process result in good transistor performance.

Although the formation of a single transistor is described above, it will be apparent that many transistors can be formed simultaneously over a large area by suitable masking, and by subsequent silicidation a multiplicity of source, gate and drain regions will be formed. Large-area arrangements cannot be formed by the conventional processes. The equipment used in such processes can produce devices on a substrate no larger than, say, 15 x 20 cms, and then only after very long processing times.

## Claims

1. A process for manufacturing a thin film transistor, characterised by the steps of forming a first polysilicon layer (11) on a substrate (10); forming a second polysilicon layer (13) over a region of said first polysilicon layer and insulated therefrom by a dielectric layer (12) of the same area as said second polysilicon layer; depositing on said second polysilicon layer and on the exposed regions of said first polysilicon layer a layer (14) of refractory metal; and causing a reaction between the metal layer and the polysilicon layers whereby silicide regions are formed to provide source, gate and drain electrodes (15,16,17).

2. A process as claimed in Claim 1, characterised in that unreacted areas of the layer (14) of refractory metal are removed by a chemical selective etching operation.

3. A process as claimed in Claim 2, characterised in that the selective etching is effected by ammonium hydroxide or a 1:1 mixture of hydrogen peroxide and sulphuric acid.

4. A process as claimed in any preceding claim, characterised in that the reaction is caused by annealing of the layers.

5. A process as claimed in Claim 4, characterised in that the annealing is effected at a temperature not less than 500°C.

6. A process as claimed in any one of Claims 1-3, characterised in that the reaction is caused by a combination of annealing and ion bombardment of the layers.

7. A process as claimed in any one of Claims 4 to 6, characterised in that after removal of unreacted areas of the layer (14) of refractory metal the layers (11,13)are further annealed to complete the silicidation process.

8. A process as claimed in any preceding claim, characterised in that the refractory metal is titanium, molybdenum, chromium or tungsten.

9. A process as claimed in any preceding claim, characterised in that the refractory metal layer (14) is deposited by an evaporation technique.

# Fig. 1(a).

# Fig. 1(b).

# Fig. 1(c).

PRIOR ART

5

# Fig.2(a).

# Fig.2(b).

# Fig.2(c).

# Fig.2(d).

# Fig.2(e).

# Fig.2(f).

## Fig.2(g).

## Fig.2(h).

## Fig.2(i).

## Fig.2(j).

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 197 531 (HITACHI)<br>* page 12, line 1 - page 13, line 5; page 13, lines 14-18; figures 4a-4g * | 1-5,7-9 | H 01 L 21/336 |
| Y | | 6 | |
| Y | PATENT ABSTRACTS OF JAPAN vol. 7, no. 247 (E-208)(1392), 2 November 1983;<br>& JP - A - 58134427 (NIPPON DENKI) 10.08.1983<br>* abstract; figures * | 6 | |
| A | idem | 3 | |
| A | EP-A-0 329 482 (GENERAL ELECTRIC)<br>* claims; figures * | 1 | |
| A | PATENT ABSTRACTS OF JAPAN vol. 5, no. 23 (E-45)(695), 12 February 1981;<br>& JP - A - 55151334 (MATSUSHITA) 25.11.1980<br>* abstract; figures * | 6 | |

**TECHNICAL FIELDS SEARCHED (Int. Cl.5)**

H 01 L

The present search report has been drawn up for all claims

| Place of search | Date of completion of search | Examiner |
|---|---|---|
| Berlin | 15 May 91 | JUHL A. |